## Europäisches Patentamt

## European Patent Office

## Office européen des brevets

(19)

(11) Veröffentlichungsnummer: **0 054 683**
**A2**

(12) # EUROPÄISCHE PATENTANMELDUNG

(21) Anmeldenummer: **81108884.8**

(22) Anmeldetag: **24.10.81**

(51) Int. Cl.³: **C 08 F 283/00**, C 08 F 281/00,
H 01 B 1/12, H 01 L 29/28,
H 01 L 31/02

(30) Priorität: **22.12.80 DE 3048445**

(43) Veröffentlichungstag der Anmeldung: **30.06.82**
**Patentblatt 82/26**

(84) Benannte Vertragsstaaten: **BE DE FR GB**

(71) Anmelder: **BASF Aktiengesellschaft,
Carl-Bosch-Strasse 38, D-6700 Ludwigshafen (DE)**

(72) Erfinder: **Naarmann, Herbert, Dr., Haardtblick 15,
D-6719 Wattenheim (DE)**
Erfinder: **Penzien, Klaus, Dr., Bensheimer Ring 18,
D-6710 Frankenthal (DE)**
Erfinder: **Naegele, Dieter, Dr., Obere Jakobstrasse 8,
D-6520 Worms (DE)**
Erfinder: **Schlag, Johannes, Dr., Leuschnerstrasse 36,
D-6700 Ludwigshafen (DE)**

(54) **Verfahren zur Herstellung von elektrisch leitfähigen polymeren Systemen und deren Verwendung in der Elektrotechnik und zur antistatischen Ausrüstung von Kunststoffen.**

(57) Die Erfindung betrifft ein Verfahren zur Herstellung von elektrisch leitfähigen Polymeren mit elektrischen Leitfähigkeitswerten größer als $10^{-2}$S/cm, wobei man in Gegenwart von organischen Polymeren aus der Reihe der Polyphenylene, Heteropolyphenylene oder Polyacetylene unter Ausschluß von Wasserfeuchtigkeit und von Sauerstoff Mono- oder Diolefine in Mengen von 0,1 bis 55 Gew.-%, mit 0,1 bis 25 Gew.-%, anionische Katalysatoren, bevorzugt bei Temperaturen zwischen 80 und 100°C, polymerisiert.

Als Mono- oder Diolefin werden α-Methylstyrol, Acrylnitril, Styrol, Butadien oder Isopren verwendet und die anionischen Katalysatoren sind Natrium, Kalium, Rubidium, Cäsium und/oder deren Amide, die bevorzugt in Tetrahydrofuran, Dimethoxyglykol, Anthracen, Naphthalin oder 2-Methylstyrol jeweils im Molverhältnis 1 : 1 bis 1 : 5 zugesetzt werden. Die elektrisch leitfähigen Polymeren können in der Elektrotechnik zur Herstellung von Sonnenzellen, zur Umwandlung und Fixierung von Strahlung, zur Herstellung elektrischer und magnetischer Schalter und zur antistatischen Ausrüstung von Kunststoffen verwendet werden.

0054683

Verfahren zur Herstellung von elektrisch leitfähigen polymeren Systemen und deren Verwendung in der Elektrotechnik und zur antistatischen Ausrüstung von Kunststoffen

Die Erfindung betrifft ein Verfahren zur Herstellung von elektrisch leitfähigen Polymeren mit elektrischen Leitfähigkeitswerten größer als $10^{-2}$ S/cm und deren Verwendung in der Elektroindustrie zur Herstellung von Sonnenzellen, zur Umwandlung und Fixierung von Strahlung und zur Herstellung elektrischer und magnetischer Schalter sowie zur antistatischen Ausrüstung von Kunststoffen.

Es ist bereits bekannt, organische Polymere aus der Reihe der Polyphenylene durch oxidative Kupplung entsprechend der Literatur: "Macromolecular Syntheses Collective", 1, (1979), Seiten 109 bis 110 und "Naturwiss." 56 (1969), Seiten 308 bis 313, herzustellen. Außerdem ist die Herstellung von Polyphenylenen durch stufenweise Polykondensation nach R. Gehm und W. Kern aus "Makromolekulare Chemie" 7 (1951), Seiten 46 bis 61, bekannt, wobei besonders einheitliche para-verkettete methylsubstituierte Derivate erhalten werden, die nicht zusätzlich durch ortho- oder meta-verknüpfte Polymere verunreinigt sind. Die organischen Polymeren aus der Reihe der Heteropolyphenylene unterscheiden sich von den Polyphenylenen durch das Vorhandensein von Heteroatomen oder Heteroatome enthaltenden Gruppen zwischen den aromatischen Ringsystemen. Diese Polymeren sind z.B. beschrieben in "Macromolecular Synthesis", 6, (1978), Seiten 45 bis 48. Auch die Herstellung der organischen Polymere aus der Reihe der Polyacetylene durch Polymerisation von Acetylen ist bekannt. Sie ist z.B. in den Arbeiten von Hatano in "J. Chem. Soc. Japan, Ind. Chem. Sect." 65, (1962), Seite 723 ff. sowie von D.J. Berets et al. "Trans. Farad. Soc." 64, (1968), Seite 823 ff. beschrieben. Auch in neueren Publikationen

Fre/BL

von H. Shirakawa et al., "J. Chem. Soc., Chem. Comn." 1977, Seiten 578 bis 580 ist die Polymerisation von Acetylen zu Polyacetylen mit Hilfe von Ziegler-Katalysatoren beschrieben. Nach den genannten Methoden werden Produkte erhalten, die in den üblichen Lösungsmitteln vollkommen unlöslich sind und als schwarze amorphe bis teilkristalline Materialien anfallen. Auch die in den "Ber. Bunsenges. Phys. Chem." 68, (1964), Seiten 558 bis 567 erhaltenen Materialien werden mit umfaßt.

Der Erfindung lag die Aufgabe zugrunde, die an sich bekannten organischen Polymeren aus der Reihe der Polyphenylene, Heteropolyphenylene oder Polyacetylene durch Zusätze in elektrisch leitfähige Polymere mit elektrischen Leitfähigkeitswerten größer als $10^{-2}$ S/cm umzuwandeln und darüber hinaus entscheidend gegen oxidative Schädigung zu stabilisieren und die Verarbeitbarkeit und Anwendungsbreite deutlich zu erhöhen.

Diese Aufgabe wird erfindungsgemäß dadurch gelöst, daß man den organischen Polymeren aus der Reihe der Polyphenylene, Heteropolyphenylene oder Polyacetylene unter Ausschluß von Wasserfeuchtigkeit und von Sauerstoff 0,1 bis 55 Gew.%, bezogen auf das Polymere, Mono- oder Diolefine, vorzugsweise Butadien, Isopren oder Styrol zugibt und mit 0,1 bis 25 Gew.%, bezogen auf das eingesetzte organische Polymere, anionische Katalysatoren, vorzugsweise Natrium, Kalium, Rubidium, Cäsium oder deren Amide polymerisiert. Nach bevorzugter Verfahrensweise werden Na, K, Rb, Cs oder deren Amide in Tetrahydrofuran, Dimethoxyglykol, Anthrazen, Naphthalin oder 2-Methylstyrol, jeweils im Molverhältnis 1 : 1 bis 1 : 50, vorzugsweise 1 : 2 bis 1 : 3, zugesetzt und bei Temperaturen zwischen -80 und +100°C, vorzugsweise zwischen -30 und +20°C polymerisiert.

0054683

Die elektrischen Leitfähigkeitswerte werden in S/cm bei 30°C gemessen, die Messung selbst erfolgt nach der Methode von F. Beck, "Berichte Bunsengesellschaft, Physikalische Chemie" 68 (1964), Seiten 558 bis 567. Die elektrische Leitfähigkeitswerte der erfindungsgemäßen leitfähigen Polymeren ist größer als $10^{-2}$ S/cm.

Nach dem erfindungsgemäßen Verfahren werden den organischen Polymeren unter Ausschluß von Wasserfeuchtigkeit und von Sauerstoff, 0,1 bis 55 Gew.%, bezogen auf das Gewicht des Polymeren, die Mono- oder Diolefine in Mengen von 0,1 bis 25 Gew.%, bezogen auf das eingesetzte Polymere, und ein anionischer Katalysator, vorzugsweise ein Alkalimetall zugesetzt und polymerisiert (entspr. der Lit. Houben-Weyl 14/1, S. 645, Georg-Thieme-Verlag Stuttgart (1961).

Das Polymerisieren erfolgt unter Ausschluß von Feuchtigkeit (Wasser) sowie Sauerstoff (Luft), es wird daher vorzugsweise unter Edelgas-Argonatmosphäre gearbeitet. Gegebenenfalls werden Hilfsflüssigkeiten wie Tetrahydrofuran, Dimethoxyglykol oder Toluol eingesetzt, die nach dem Einarbeiten bei Temperaturen unter 30°C in Vakuum abgezogen werden.

Durch das erfindungsgemäße Verfahren können elektrisch leitfähige Systeme mit hoher Stabilität erreicht werden. Die Ausgangsleitfähigkeit der organischen Polymeren betrugen $10^{-12}$ S/cm. Die erfindungsgemäßen organischen Polymeren haben Ausgangsleitfähigkeiten von weniger als $10^{-12}$ S/cm, liefern aber nach dem erfindungsgemäßen Verfahren Leitfähigkeiten größer als $10^{-2}$ S/cm. Die Polymeren können als Pulver, Filme, Granulate oder Fasern vorliegen Die erfindungsgemäß hergestellten elektrisch leitfähigen polymeren Systeme mit elektrischen Leitfähigkeiten größer als $10^{-2}$ S/cm sind zur antistatischen Ausrüstung von Kunststoffen, zur Herstellung von Sonnenzellen, zur Umwandlung, Abschirmung und Fixierung von Strahlung sowie zur Herstellung elektrischer und magnetischer Schalter geeignet. Durch die Zusätze der Alkalimetalle bzw. deren Amide oder Hydride entstehen sog. n-Leiter (vgl. "J. Chem. Education", 46, (1969), Nr. 2, Seite 82).

Die in den folgenden Beispielen genannten Teile sind Gewichtsteile bzw. Molprozente.

Beispiele 1 bis 7

10 Teile eines organischen Polymeren werden unter Argonatmosphäre und Ausschluß von Feuchtigkeit mit dem jeweiligen Monomeren und Katalysator versetzt und polymerisiert, die Messung der elektrischen Leitfähigkeit erfolgt nach der Aufarbeitung nach der Methode von F. Beck "Ber. Bunsenges. Phys. Chem." 68, (1964), Seiten 558 bis 567.

1,25 Teile $\alpha$-Methylstyrol werden mit 10 Teilen eines der erfindungsgemäßen Polymeren unter Argon versetzt und bei 15°C 12 Stunden mit 1 Teil Kalium polymerisiert, anschließend wird noch 1 Stunde auf 50°C erhitzt, anschließend wird evakuiert, 10 Stunden bei 50°C und 0,1 Torr.

Tabelle 1

| Beispiel Nr. | organ. Polymeres Teile | Katalysator Art und Menge in Teilen | | Leitfähigkeit S/cm 30°C vor dem Zusatz | nach dem Zusatz |
|---|---|---|---|---|---|
| | 10 | | | | |
| 1 | Polyacetylen nach Shirakawa 1) | Na | 2 | $10^{-10}$ | $0,1 \cdot 10^{+2}$ |
| 2 | " | K | 2 | $10^{-10}$ | $0,8 \cdot 10^{+2}$ |
| 3 | " | Cs | 2 | $10^{-10}$ | $1,0 \cdot 10^{+2}$ |
| 4 | " | $Na^{3)}$ | 2 | $10^{-10}$ | $0,5 \cdot 10^{+2}$ |
| 5 | " | $Na^{3)}$ | 2,5 | $10^{-10}$ | $1,5 \cdot 10^{+2}$ |
| 6 | " | $Na^{3)}$ | 3 | $10^{-10}$ | $2,5 \cdot 10^{+2}$ |
| 7 | Polyacetylen nach Lüttinger 2) | $Na^{3)}$ | 2 | $10^{-10}$ | $0,7 \cdot 10^{+1}$ |
| 8 | Polyacetylen nach Shirakawa 1) | $Na^{4)}$ | 2,5 | $10^{-10}$ | $7,5 \cdot 10^{+1}$ |
| 9 | " | $Na^{4)}$ | 3,0 | $10^{-10}$ | $8,0 \cdot 10^{+1}$ |
| 10 | " | $Na^{4)}$ | 3,5 | $10^{-10}$ | $3,8 \cdot 10^{+2}$ |
| 11 | " | $Na^{4)}$ | 4,0 | $10^{-10}$ | $5,5 \cdot 10^{+2}$ |

1) J. Chem. Soc., Chem. Commn. 1977, 578 ff.

2) J. Org. Chem. 29 (1964) 2936 ff.

3) Na als Na-Naphthalid, 2,5 %ig in Tetrahydrofuran

4) Na in flüssigem $NH_3$

0054683

O.Z. 0050/034634

## Beispiele 12 bis 18

Wird wie in den vorgehenden Beispielen gearbeitet, jedoch α-Methylstyrol durch Butadien ersetzt, so werden die folgenden Ergebnisse erzielt.

## Beispiele 19 bis 21

Wird α-Methylstyrol durch Acrylnitril ersetzt, so werden die folgenden Ergebnisse erzielt.

Tabelle 2

| Beispiel Nr. | organ. Polymeres Teile | Katalysator Art und Menge in Teilen | | Leitfähigkeit S/cm 30°C vor dem Zusatz | nach dem Zusatz |
|---|---|---|---|---|---|
| 12 | Polyacetylen nach Shirakawa 1) | Na | 2 | $10^{-10}$ | $0,08 \cdot 10^{+2}$ |
| 13 | " | K | 2 | $10^{-10}$ | $0,2 \cdot 10^{+2}$ |
| 14 | " | Cs | 2 | $10^{-10}$ | $0,5 \cdot 10^{+2}$ |
| 15 | " | Na[3] | 2 | $10^{-10}$ | $1,0 \cdot 10^{+2}$ |
| 16 | " | Na[3] | 2,5 | $10^{-10}$ | $2,0 \cdot 10^{+2}$ |
| 17 | " | Na[3] | 3 | $10^{-10}$ | $0,1 \cdot 10^{+2}$ |
| 18 | Polyacetylen nach Lüttinger 2) | Na[3] | 2 | $10^{-10}$ | $0,5 \cdot 10^{+1}$ |
| 19 | Polyacetylen nach Shirakawa 1) | Na[4] | 2,5 | $10^{-10}$ | $5,0 \cdot 10^{+1}$ |
| 20 | " | Na[4] | 3,0 | $10^{-10}$ | $3,5 \cdot 10^{+1}$ |
| 21 | " | Na[4] | 3,5 | $10^{-10}$ | $1,0 \cdot 10^{+2}$ |
| 21 | " | Na[4] | 4,0 | $10^{-10}$ | $2,7 \cdot 10^{+2}$ |

1) J. Chem. Soc., Chem. Commn. 1977, 578 ff.

2) J. Org. Chem. 29 (1964) 2936 ff.

3) Na als Na-Naphthalid, 2,5 %ig in Tetrahydrofuran

4) Na in flüssigem $NH_3$

## Patentansprüche

1. Verfahren zur Herstellung von elektrisch leitfähigen Polymeren mit elektrischen Leitfähigkeitswerten größer als $10^{-2}$ S/cm, dadurch gekennzeichnet, daß man in Gegenwart von organischen Polymeren aus der Reihe der Polyphenylene, Heteropolyphenylene oder Polyacetylene unter Ausschluß von Wasserfeuchtigkeit und von Sauerstoff Mono- oder Diolefine in Mengen von 0,1 bis 55 Gew.%, bezogen auf das Polymere, mit 0,1 bis 25 Gew.%, bezogen auf das Polymere, anionische Katalysatoren polymerisiert.

2. Verfahren nach Anspruch 1, dadurch gekennzeichnet, daß als Mono- oder Diolefin α-Methylstyrol, Acrylnitril, Styrol, Butadien oder Isopren verwendet wird.

3. Verfahren nach Anspruch 1, dadurch gekennzeichnet, daß die anionischen Katalysatoren Natrium, Kalium, Rubidium, Cäsium und/oder deren Amide sind.

4. Verfahren nach Ansprüchen 1 und 3, dadurch gekennzeichnet, daß Na, K, Rb, Cs oder deren Amide in Tetrahydrofuran, Dimethoxyglykol, Anthracen, Naphthalin oder 2-Methylstyrol jeweils im Molverhältnis 1 : 1 bis 1 : 5, vorzugsweise 1 : 2 bis 1 : 3 zugesetzt und bei Temperaturen zwischen -80 und +100°C polymerisiert wird.

0054683

5. Verwendung der nach Anspruch 1 hergestellten, elektrisch leitfähigen Polymeren in der Elektrotechnik zur Herstellung von Sonnenzellen, zur Umwandlung und Fixierung von Strahlung und zur Herstellung elektrischer und magnetischer Schalter.

6. Verwendung der nach Anspruch 1 hergestellten, elektrisch leitfähigen Polymeren zur antistatischen Ausrüstung von Kunststoffen.